# EUROPEAN PATENT SPECIFICATION

(11) **EP 1 408 534 B1**
(45) Date of publication and mention of the grant of the patent: **07.02.2007**
(21) Application number: 02292517.6
(22) Date of filing: 11.10.2002
(51) Int. Cl.: H01L 21/00, H01L 21/306, H01L 21/316

(54) **A method and a device for producing an adhesive surface of a substrate**
Verfahren und Vorrichtung zur Herstellung einer haftenden Substratoberfläche
Procédé et dispositif pour la fabrication d'une surface adhésive d'un substrat

(43) Date of publication of application: 14.04.2004
(73) Proprietor: S.O.I. Tec Silicon on Insulator Technologies S.A., 38190 Bernin (FR)
(72) Inventor: Maleville, Christophe, 38660 La Terrase (FR); Maunand-Tussot, Corinne, 38240 Meylan (FR)
(74) Representative: Grünecker, Kinkeldey, Stockmair & Schwanhäusser Anwaltssozietät

(56) References cited:
- EP-A- 0 476 897
- US-A- 5 158 100
- US-A- 5 727 578
- US-A1- 2002 050 279

## Description

The present invention relates to a method for producing an adhesive surface of a substrate, especially a silicon wafer, with the features cited in the preamble of claim 1 and to a corresponding device with the features cited in the preamble of claim 7.

In 1986, Lasky and Shimbo succeeded in bonding two silicon wafers and in increasing the bonding strength by an annealing so that further processing of a bonded wafer pair was possible. Now, silicon wafer bonding is an important technology step in various parts of semiconductor technology such as in MEMS (Micro Electro Mechanical Systems) or in SOI technologies.

Dependent on the specification of the silicon surface, hydrophobic and hydrophilic direct wafer bonding have to be differentiated. A conventional silicon wafer has normally a few Ångström thick native silicon dioxide layer on its surface. On this oxide layer, silanol sites (-Si-OH) are chemisorbed which absorb water molecules from the atmosphere so that a water film being a few mono-layers thick is formed on the surface. This surface is water-attractive or hydrophilic. Hydrophilic surfaces are very reactive and therefore easily contaminated. When the hydrophilic silicon surface is exposed to a hydrofluoric acid solution, the silicon dioxide will be fully removed from the surface. The remaining pure silicon surface is saturated with hydrogen. Such a surface is water-repellent or hydrophobic.

In hydrophilic wafer bonding, hydrogen bonds which are formed already at room temperature between the adjacent water molecules or the silanol sites of the opposite wafer surfaces determine the bonding strength. By a temperature treatment of the bonded wafers, the chemical and physical structure of the bonding in the wafer is changed. Between room temperature and about 200°C, the water molecules diffuse along the interface and closest Si-OH sites interact forming siloxane compounds (-Si-O-Si-). Between about 200°C and 900°C, depending on the roughness of the wafers to bond, the water molecules can further diffuse to the pure silicon and react with the silicon by forming molecular hydrogen and silicon dioxide. Due to the migration of the interface water molecules, the silanol sites get closer to each other until they react or condense by forming a covalent siloxane compound splitting off a water molecule. A further annealing step at a temperature between about 800°C and 1000°C increases the bonding strength.

It is necessary to clean the wafers before bonding to remove organic and inorganic contamination on the wafers. This can be achieved by a wet chemical cleaning and etching in one or more baths with cleaning fluids such as in a RCA-cleaning procedure or by a dry chemical etching of a contamination, e.g. in a O₂-plasma.

The conventional RCA-cleaning is often complemented or replaced by other more effective cleaning methods like the method of the above-mentioned type described in EP 0 731 495 A2, in which silicon wafers are cleaned in an etchant consisting of an aqueous solution containing hydrofluoric acid (HF) and a tenside, wherein an ozone (O₃) gas flow is flown through the solution. This etchant is especially suited for the removal of metallic or organic contamination on a silicon wafer. The increased solubility of ozone in aqueous HF leads to an increased formation of OH-radicals resulting in an enhanced particle reduction on the cleaned surfaces. In this method, after the oxide removal, the HF concentration of the solution is reduced to 0% so that the ozone flows through pure DI-water, and the silicon wafer surfaces which were hydrophobic due to the HF treatment can be taken hydrophilic from the bath.

In hydrophilic bonding methods, it is furthermore necessary to provide an optimum of water on the wafer surface. Too much water can lead to extensive water inclusions or water vapor bubbles at the bonding interface causing the wafers to de-bond. Therefore, a very accurate DI-water rinsing and drying method has to be applied on the wafers to get only several mono layers of water on the wafer surfaces before bonding.

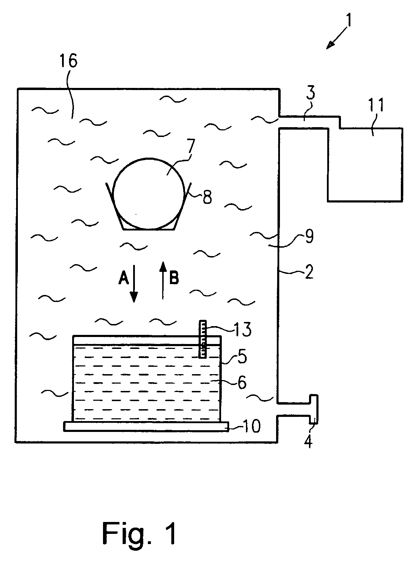

EP 0 476 897 A2 discloses a method of the above-mentioned type in which an adhesive agent used in keeping a wafer held fast on a carrier plate during polishing, an abrasive and particles produced by the polishing, are expelled from the surface by washing the surface with NH₃/H₂O₂, H₂SO₄/H₂O₂, HCl/H₂O₂, HF or i-C₃H₇OH. After the washing step, such defiling substances as C, H, S and Cl are removed from the washed surface separately, as illustrated in Fig. 1a therein, where the surface of the wafer is it radiated with an ultraviolet light source in an atmosphere of oxygen, causing ozone to be generated to purge the surface.

It is the object of the present invention to create a method and a device of the above-mentioned type which is easy to carry out and suitable for effectively producing a bondable surface of the substrate.

The object is solved with a method of the above-mentioned type characterised in that subsequently after wet chemical etching the surface is exposed to a gaseous ozone atmosphere.

The method of the present invention enables producing of an adhesive surface suitable for bonding with a very simple and efficient technology. The surface sites of a pure surface produced by wet chemical etching removing an oxide on the surface, are simply saturated with oxygen in a gaseous atmosphere. Therefore, a pure oxide layer can be created on the surface of the substrate making the surface hydrophilised in a dry way. This leads to an adhesive surface providing an enhanced adhesion quality between two bonded surfaces.

The inventive method has the effect to make the surface hydrophilic and dry. Therefore, a recontamination of the surface can be reduced and the produced adhesive surface has a reduced particle concentration in comparison to wet hydrophilised wafers.

With the use of silicon wafers, the surfaces have only to be wet chemically etched removing silicon dioxide on the surface creating a hydrophobic surface which can subsequently be made hydrophilic in the gaseous ozone atmosphere after chemical etching. By this method a high density of silanol sites (Si-OH) is formed on the surface whereas only a small quantity of water molecules is absorbed on these sites.

In a further embodiment of the invention, the etchant consists of an aqueous hydrofluoric acid solution (HF).

HF is a good etchant of oxide, especially of silicon dioxide, which effectively removes the oxide on the surface of the substrate.

In another embodiment of the present invention, the etchant comprises the components hydrofluoric acid, ammonium fluoride and water.

With these components of the etchant, an oxide, especially silicon dioxide, on a surface like silicon can be removed with a higher efficiency.

In a favourable embodiment of the present invention an etch time of chemical etching is in the range of about 5 seconds to about 30 minutes.

In this relatively short time especially a native oxide on the surface of the substrate can be fully removed to get a pure surface of the substrate as a good basis for the subsequent exposure to gaseous ozone.

In an advantageous embodiment of the invention, an etch temperature of the chemical etching is in the range between room temperature of about 19°C to 25 °C and about 80°C.

In this temperature range an oxide on the surface of the substrate can be effectively removed to get a good basis for the subsequent exposure to a gaseous ozone atmosphere.

In a further variant of the invention, the substrate is etched in a bath and when it is taken out of the bath, it is directly brought into a room comprising gaseous ozone.

With this method a recontamination of the etched surface can be prevented because the etched surface can be immediately saturated with oxygen after being brought out of the etch bath.

The object of the invention can further be solved by a device for producing an adhesive surface of a substrate, especially a silicon wafer, which can be bonded to another substrate, said device having a bath with an etchant for removing an oxide from said surface, said bath being adjacent to a room having a gaseous atmosphere characterised in that said atmosphere in said room is a gaseous ozone atmosphere.

With this simple but efficient device, the substrate can be directly brought from the bath into the gaseous atmosphere. This offers the possibility that the surface of the substrate can be effectively cleaned in the bath to get a pure surface which surface sites can be saturated in the gaseous ozone atmosphere with oxygen immediately after etching. The surface produced in this device has a good adhesion characteristic and is suitable for bonding.

In a further embodiment of the invention, the room is provided in a sealed equipment.

The sealed equipment ensures a necessary ozone concentration in the equipment and prevents any contamination from the outside. Therefore, it is possible to produce a uniform oxygen saturated surface resulting in a good hydrophilicity of the surface.

In a further advantageous embodiment of the invention, the equipment is coupled with an ozone generator.

The ozone generator provides an ozone atmosphere in the equipment having a concentration which is high enough to saturate the surface sites on the etched surface with oxygen to get a well dry hydrophilised surface of the substrate.

Advantageous embodiments of the invention are described in the following description with reference to the accompanying figures, wherein:
Fig. 1 shows an embodiment of the device of the present invention;
Figs. 2 to 7 show an embodiment according to the present invention with several steps of the method of the present invention, wherein

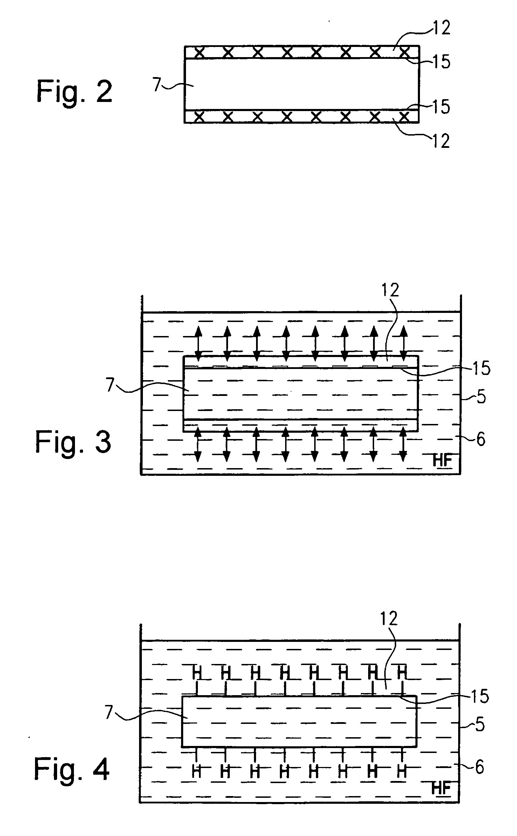

Fig. 2 shows a silicon wafer with a native oxide on its surfaces before wet chemical etching;
Fig. 3 shows the silicon wafer of Fig. 2 during etching in a bath with an etchant;
Fig. 4 shows the silicon wafer of Figs. 2 and 3 after etching in the bath;

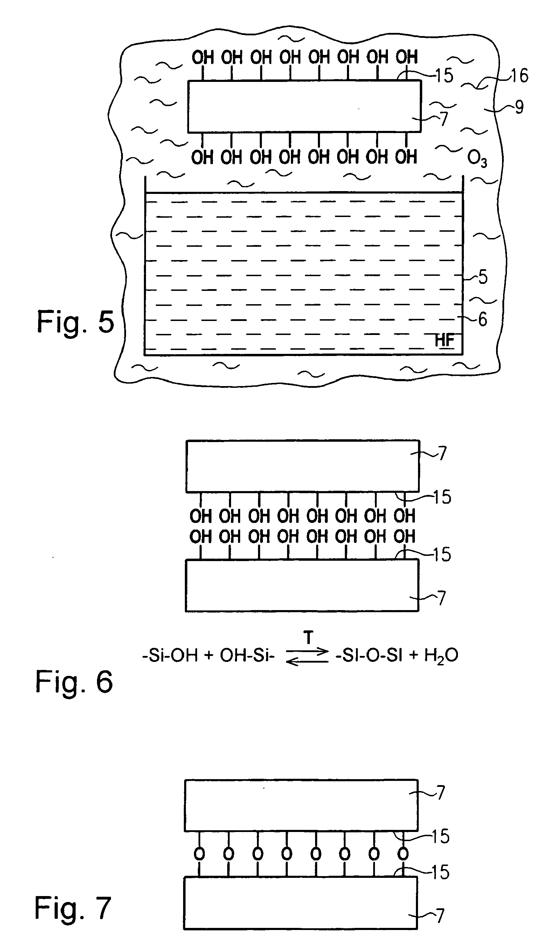

Fig. 5 shows the silicon wafer of Figs. 2 to 4 brought from the bath into an ozone atmosphere;
Fig. 6 shows the silicon wafer of Figs. 2 to 5 bonded with another silicon wafer directly after bonding; and
Fig. 7 shows the bonded wafer pair of Fig. 6 after a temperature treatment.

Fig. 1 shows a device 1 according to the present invention comprising a sealed off container 2 with an inlet 3 coupled with an ozone generator 11 and with an outlet 4 coupled with waste disposal (not shown).

A bath 5 is placed in the container 2. The bath 5 contains an etchant 6 consisting of an aqueous hydrofluoric acid solution (HF) 6. The bath 5 can further comprise ozone. In an alternative embodiment, the bath can further contain ammonium fluoride (NH₄F). The bath is coupled with a heating 10 by the which the temperature of the bath can be adjusted between room temperature which is approximately 19°C to 25°C, and about 80°C. The temperature is controlled with a sensor 13 in the bath. The bath can be recirculated and filtered to provide a homogenous temperature and concentration of the etchant 6 in the bath 5.

A wafer holder 8 is provided in the container 2. The wafer holder 8 consists of an etch resistant material such as teflon. One or more silicon wafers 7 stand erect or inclined in the wafer holder 8. The wafers 7 are held on their edges by the wafer holder 8, so that their large flat surfaces are open and accessible to the fluid.

The inner room of the container 2 contains a gaseous ozone atmosphere 16 with an ozone concentration in a range between 1 to 15 ppm. The atmosphere of the room 9 can further contain HF vapour and air.

Figs. 2 to 7 show a silicon wafer 7 in different states according to the method steps of an embodiment of the present invention.

Fig. 2 shows a silicon wafer 7 with native silicon oxide layers 12 on its large flat surfaces 15. The native oxide 12 is a few Ångström thick, respectively. As shown in Fig. 1, one or more wafers 7 of this state can be put in the wafer holder 8 to stand erect or inclined.

As shown by arrow A in Fig. 1, the wafer holder 8 including the wafer 7 is immersed in the bath 5 containing the etchant 6 so that the etchant 6 fully surrounds the wafer 7 as shown in Fig. 3.

In the shown embodiment, the etchant 6 has a temperature of about 60°C. In another embodiment, the temperature of the etchant can be adjusted to another value between approximately room temperature and about 80°C.

As shown in Fig. 3, the etchant 6, especially the HF, reacts with the silicon dioxide 12. After several seconds to several minutes the native oxide 12 is fully removed from the surface 15. The remaining pure silicon surface 15 is then essentially saturated with hydrogen (H), as shown in Fig. 4.

In the following step which is shown in Fig. 5, the etched wafer 7 standing in the wafer holder 8 is taken out of the bath 5 and is brought directly into the gaseous ozone atmosphere 16 surrounding the bath 5 in the inner room 9 of the container 2. There, the ozone (O₃) reacts with the hydrogen on the surface 15 forming silanol sites (-Si-OH) on the surface 15.

In step 6, two silicon wafers 7 which are etched as described before, are brought together in a bonding equipment (not shown). The wafers are bonded in a conventional way laying wafer 7 on the other wafer 7 and applying pressure on the upper wafer resulting in a spontaneous spreading of a bonding wave therebetween forming a bonded wafer pair. As shown in Figs. 6 and 7, the adjacent silanol sites (-Si-OH) of the opposite surfaces 15 of the wafers 7 react with each other at a certain temperature to siloxane sites (-Si-O-Si-) and water. Then, the wafers are annealed at a temperature of about 500°C. The bonded wafers show a very good bonding strength in the range between 0.28 and 0.38 MPa at room temperature.

Although, the described embodiment shows the method of the present invention with reference to silicon wafers, the method can also be applied to any polished surfaces of metals, semiconductors and non-conductive materials which are bondable. The method can also be applied on only one silicon wafer which can be bonded with another silicon wafer having silicon dioxide on its surface. Furthermore, the wafer can be cleaned before wet chemical etching with conventional RCA-cleaning or plasma treating to get a pre-cleaned surface.

## Claims

1. A method for producing an adhesive surface of a substrate (7), which can be bonded to a surface of another substrate, **characterised in that** said method comprises a removal of an oxide (12) from the surface by wet chemical etching using an etchant (6) in a device (1), and an exposure of the surface to a gaseous ozone atmosphere (16) directly after wet chemical etching in the same device.

2. The method according to claim 1, **characterised in that** said etchant (6) consists of an aqueous hydrofluoric acid solution (HF).

3. The method according to claim 1, **characterised in that** said etchant (6) comprises the components hydrofluoric acid (HF), ammonium fluoride (NH₄F) and water.

4. The method according to at least one of the preceeding claims, **characterised in that** an etch time of wet chemical etching is in the range of 5 seconds to 30 minutes.

5. The method according to at least one of the proceeding claims, **characterised in that** an etch temperature of wet chemical etching is between 19°C and 80°C.

6. The method according to at least one of the preceeding claims, **characterised in that** the substrate is etched in a bath (5) and when it is taken out of the bath it is directly brought into a room (9) comprising a gaseous ozone atmosphere (16).

7. A device (1) for producing an adhesive surface of a substrate (7), which can be bonded to another substrate, **characterised in that** said device has a bath (5) with an etchant (6) for removing an oxide (12) from said surface, said bath being placed in a room (9) containing a gaseous ozone atmosphere (16).

8. The device according to claim 7, **characterised in that** said room (9) is provided in a sealed equipment (2).

9. The device according to claim 8, **characterised in that** the equipment (2) is coupled with an ozone generator (11).

## Patentansprüche

1. Ein Verfahren zum Erzeugen einer adhäsiven Oberfläche eines Substrates (7), welche mit einer Oberfläche eines anderen Substrates gebondet werden kann, **dadurch gekennzeichnet, dass** das Verfahren ein Entfernen eines Oxides (12) von der Oberfläche durch nasschemisches Ätzen unter Verwendung eines Ätzers (6) in einer Vorrichtung (1), und ein Aussetzen der Oberfläche an einer gasförmigen Ozonatmosphäre (16) direkt nach dem nasschemischen Ätzen in der gleichen Vorrichtung aufweist.

2. Das Verfahren nach Anspruch 1, **dadurch gekennzeichnet, dass** der Ätzer (6) aus einer wässrigen Fluorwasserstoffsäurelösung (HF) besteht.

3. Das Verfahren nach Anspruch 1, **dadurch gekennzeichnet, dass** der Ätzer (6) die Komponenten Fluorwasserstoffsäure (HF), Ammoniumfluorid (NH₄F) und Wasser aufweist.

4. Das Verfahren nach wenigstens einem der vorhergehenden Ansprüche, **dadurch gekennzeichnet, dass** eine Ätzzeit des nasschemischen Ätzens in dem Bereich von 5 Sekunden bis 30 Minuten ist.

5. Das Verfahren nach wenigstens einem der vorhergehenden Ansprüche, **dadurch gekennzeichnet, dass** eine Ätztemperatur des nasschemischen Ätzens zwischen 19 °C und 80 °C ist.

6. Das Verfahren nach wenigstens einem der vorhergehenden Ansprüche, **dadurch gekennzeichnet, dass** das Substrat in einem Bad (5) geätzt wird und es, wenn es aus dem Bad genommen wird, direkt in einen Raum (9) gebracht wird, der eine gasförmige Ozonatmosphäre (16) aufweist.

7. Eine Vorrichtung (1) zum Herstellen einer adhäsiven Oberfläche eines Substrates (7), welches mit einem anderen Substrat gebondet werden kann, **dadurch gekennzeichnet, dass** die Vorrichtung ein Bad (5) mit einem Ätzer (6) zum Entfemen eines Oxides (12) von der Oberfläche hat, wobei das Bad in einem Raum (9) platziert ist, der eine gasförmige Ozonatmosphäre (16) enthält.

8. Vorrichtung nach Anspruch 7, **dadurch gekennzeichnet, dass** der Raum (9) in einer abgedichteten Vorrichtung (2) vorgesehen ist.

9. Die Vorrichtung nach Anspruch 8, **dadurch gekennzeichnet, dass** die Vorrichtung (2) mit einem Ozongenerator (11) gekoppelt ist.

## Revendications

1. Procédé de production d'une surface adhésive d'un substrat (7), qui peut être liée à une surface d'un autre substrat, **caractérisé en ce que** ledit procédé comprend une élimination d'un oxyde (12) de la surface par une gravure chimique humide utilisant un agent de gravure (6) dans un dispositif (1), et une exposition de la surface à une atmosphère d'ozone gazeuse (16) directement après la gravure chimique humide dans le même dispositif.

2. Procédé selon la revendication 1, **caractérisé en ce que** ledit agent de gravure (6) consiste en une solution aqueuse d'acide fluorhydrique (HF).

3. Procédé selon la revendication 1, **caractérisé en ce que** ledit agent de gravure (6) comprend les composants suivants : de l'acide fluorhydrique (HF), du fluorure d'ammonium (NH₄F) et de l'eau.

4. Procédé selon au moins l'une des revendications précédentes, **caractérisé en ce qu'**une durée de gravure de la gravure chimique humide est comprise dans une gamme située entre 5 secondes et 30 minutes.

5. Procédé selon au moins l'une des revendications précédentes, **caractérisé en ce qu'**une température de gravure de la gravure chimique humide est comprise entre 19°C et 80°C.

6. Procédé selon au moins l'une des revendications précédentes, **caractérisé en ce que** le substrat est gravé dans un bain (5) et lorsqu'il est extrait du bain, il est directement transféré dans une region (9) comprenant une atmosphère d'ozone gazeuse (16).

7. Dispositif (1) de production d'une surface adhésive d'un substrat (7), qui peut être liée à un autre substrat, **caractérisé en ce que** ledit dispositif comporte un bain (5) avec un agent de gravure (6) pour éliminer un oxyde (12) de ladite surface, ledit bain étant placé dans une region (9) contenant une atmosphère d'ozone gazeuse (16).

8. Dispositif selon la revendication 7, **caractérisé en ce que** ladite region (9) est disposée dans un équipement hermétique (2).

9. Dispositif selon la revendication 8, **caractérisé en ce que** l'équipement (2) est couplé avec un générateur d'ozone (11).
